# EUROPEAN PATENT APPLICATION

(11) **EP 2 146 437 A1**
(43) Date of publication of application: **20.01.2010**
(21) Application number: 08722301.2
(22) Date of filing: 17.03.2008
(51) Int. Cl.: H04B 1/04, H04M 1/00, H04M 1/73

(54) **COMMUNICATION APPARATUS, COMMUNICATION CONTROL METHOD, AND COMMUNICATION CONTROL PROGRAM**

(30) Priority: 19.04.2007 JP 2007110894
(71) Applicant: Nec Corporation, Tokyo 108-8001 (JP)
(72) Inventor: SEKITA, Suguru, Kodama-gun Saitama 367-0297 (JP)
(74) Representative: Glawe, Delfs, Moll
(86) International application number: PCT/JP2008/054907
(87) International publication number: WO 2008/132889

(57) **Abstract**

A communication apparatus capable of controlling the power supply of an amplifier for amplifying the power of a carrier wave, maintaining the output level of the carrier wave constant by the open-close state of the communication apparatus, and performing stable communication is provided. It is judged that the communication apparatus is in an open state or in a closed state. If the communication apparatus is in the closed state, the power supply of a power amplifier (5) is controlled to the activated state. If the communication apparatus is in the open state, the power supply of the power amplifier (5) is controlled to the stopped state.

## Description

### TECHNICAL FIELD

The present invention relates to a communication apparatus of a mobile phone or the like and a communication control method and a communication control program of the communication apparatus, and more particularly, to a communication apparatus mounting an FM transmitter function and a communication control method and a communication control program of the communication apparatus.

### BACKGROUND ART

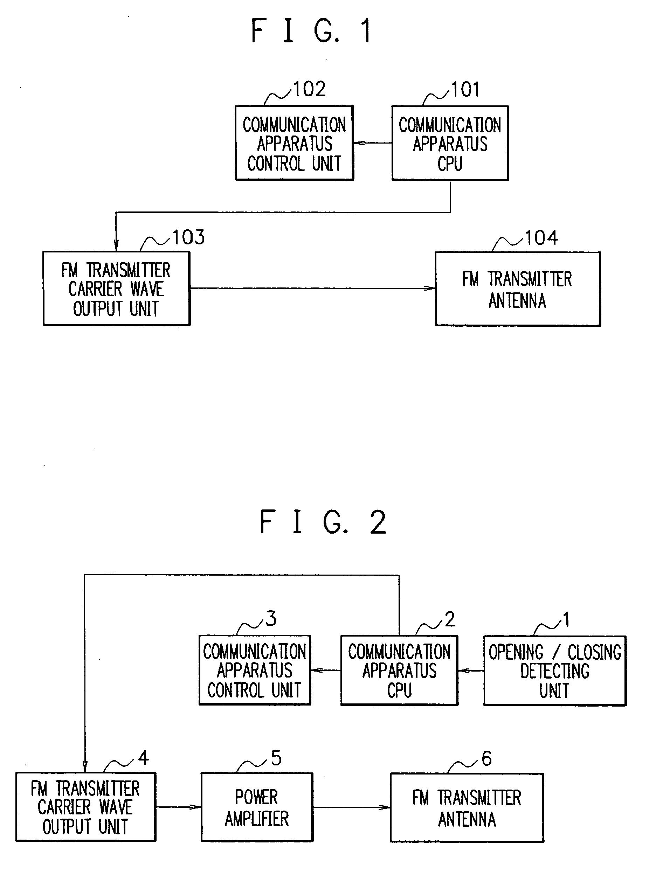

First, a processing operation of a communication apparatus relating to the present invention will be described with reference to Fig. 1.
Fig. 1 is a diagram illustrating a structure of a communication apparatus mounting an FM transmitter function.

As shown in Fig. 1, the communication apparatus relating to the present invention includes a communication apparatus CPU 101, a communication apparatus control unit 102, an FM transmitter carrier wave output unit 103, and an FM transmitter antenna 104. The communication apparatus outputs a carrier wave, which is delivered from the FM transmitter carrier wave output unit 103, to the outside of the communication apparatus through the FM transmitter antenna 104.

In the communication apparatus shown in Fig.1, since efficiency of the FM transmitter antenna 104 differs between an open state and a closed state of the communication apparatus, the output level of the carrier wave delivered from the FM transmitter antenna 104 becomes unstable by the open-close state of the communication apparatus, therefore it may causes a fear of unstable communication.

Incidentally, to give an example about the open-close state of the communication apparatus in a case of a foldable mobile phone, a state in which the mobile phone is folded corresponds to the closed state, and a state in which the phone is not folded corresponds to the opened state.

Thus it is required to develop a control method capable of maintaining the output level of the carrier wave constant by the open-close state of the communication apparatus and performing stable communication.

As a related art, a foldable mobile terminal capable of performing impedance matching suited to respective cases of telephone call state and incoming waiting state is disclosed (for example, Patent Document 1).

Further, a related art in which an optimal signal line is selected from a plurality of signal lines having different gains provided by respective signal amplifying devices to perform gain adjustment on a signal to be transmitted, which is supplied to an input terminal, so as to optimize power consumption of each signal amplifying device in accordance with a gain value, and to halt the operation of the signal amplifying device on a signal line which is not selected, thereby unnecessary power consumption can be suppressed is disclosed (for example, Patent Document 2).

Furthermore, for example, Patent Document 3 discloses, in a deformable portable telephone and a portable telephone to/from which an external device can be attached or detached, a portable telephone that does not exceed the upper limit value of electric field strength stipulated in a law even though deformed and even though an external device is attached/detached.
Patent Document 1: Japanese Patent Application Laid-Open No. 2001-345882
Patent Document 2: Japanese Patent Application Laid-Open No. 2006-60855
Patent Document 3: Japanese Patent Application Laid-Open No. 2007-19863

### DISCLOSURE OF THE INVENTION

### PROBLEM TO BE SOLVED BY THE INVENTION

However, the above-described Patent Documents 1 to 3 neither disclose nor suggest necessity for permitting of controlling a power supply of an amplifier for amplifying the power of a carrier wave, maintaining the output level of the carrier wave constant by the open-close state of the communication apparatus and performing stable communication.

The present invention is made in view of the above described circumstances, and an exemplary object of the present invention is to solve the above problem and to provide a communication apparatus, a communication control method and a communication control program capable of controlling a power supply of an amplifier for amplifying the power of a carrier wave, maintaining the output level of the carrier wave constant by the open-close state of the communication apparatus and performing stable communication.

### MEANS FOR SOLVING THE PROBLEM

To attain the above exemplary object, the present invention includes the following technical characteristics.

### [Communication apparatus]

A communication apparatus in accordance with an exemplary aspect of the present invention is a communication apparatus that includes an amplifier for amplifying the power of a carrier wave, the communication apparatus includes control means for judging whether the communication apparatus is in an open state or a closed state; and controlling a power supply of the amplifier to an activated state when the communication apparatus is in the closed state, and controlling the power supply of the amplifier to a stopped state when the communication apparatus is in the open state.

### [Communication control method]

A communication control method in accordance with an exemplary aspect of the present invention is a communication control method performed in a communication apparatus that includes an amplifier for amplifying the power of a carrier wave, the communication control method includes a controlling step of judging whether the communication apparatus is in an open state or a closed state; and controlling a power supply of the amplifier to an activated state when the communication apparatus is in the closed state, and controlling the power supply of the amplifier to a stopped state when the communication apparatus is in the open state.

### [Communication control program]

A communication control program in accordance with an exemplary aspect of the present invention is a communication control program executed in a communication apparatus that includes an amplifier for amplifying the power of a carrier wave, the communication control program causes the communication apparatus to execute process including controlling process of judging whether the communication apparatus is in an open state or a closed state; and controlling a power supply of the amplifier to an activated state when the communication apparatus is in the closed state, and controlling the power supply of the amplifier to a stopped state when the communication apparatus is in the open state.

### EFFECTS OF THE INVENTION

The present invention makes it possible to control a power supply of an amplifier for amplifying the power of a carrier wave, maintain the output level of the carrier wave constant by the open-close state of the communication apparatus and perform stable communication.

### BEST MODE FOR CARRYING OUT THE INVENTION

### [Outline of communication apparatus]

An outline of a communication apparatus according to an exemplary embodiment will be described with reference to Fig. 2.

A communication apparatus in accordance with an exemplary embodiment is a communication apparatus that includes an amplifier (corresponding to a power amplifier 5) for amplifying a power of a carrier wave. The communication apparatus judges whether the communication apparatus is in an open state or a closed state, controls a power supply of the amplifier 5 to an activated state when the communication apparatus is in the closed state, and controls the power supply of the amplifier 5 to a stopped state when the communication apparatus is in the open state.

Accordingly, it is possible to control the power supply of the amplifier 5 for amplifying the power of a carrier wave, maintain the output level of the carrier wave constant by the open-close state of the communication apparatus, and perform stable communication. A description will be given hereinbelow to the communication apparatus according to the exemplary embodiment with reference to the drawings.

### [Structure of communication apparatus]

At first, a structure of the communication apparatus according to the exemplary embodiment will be described with reference to Fig. 2.

The communication apparatus according to the exemplary embodiment includes an opening-closing detecting unit 1, a communication apparatus CPU 2, a communication apparatus control unit 3, an FM transmitter carrier wave output unit 4, a power amplifier 5, and an FM transmitter antenna 6.

### [Opening-closing detecting unit 1]

The opening-closing detecting unit 1 detects whether the communication apparatus is in an open state or in a closed state. The opening-closing detecting unit 1 outputs a control signal for identifying whether the communication apparatus is in the open state or in the closed state to the communication apparatus CPU 2.

### [Communication apparatus CPU 2]

The communication apparatus CPU 2 controls the whole communication apparatus.

In a case of using an FM transmitter, the communication apparatus CPU 2 according to the exemplary embodiment outputs a control signal to the FM transmitter carrier wave output unit 4 and controls the FM transmitter carrier wave output unit 4 so as to output a carrier wave.

Further, the communication apparatus CPU 2 judges whether the communication apparatus in the open state or in the closed state based on the control signal inputted from the opening-closing detecting unit 1, and outputs a control signal according to the open or closed state to the communication apparatus control unit 3.

### [Communication apparatus control unit 3]

The communication apparatus control unit 3 controls an ON/OFF state of the power supply of the power amplifier 5 based on the control signal inputted from the communication apparatus CPU 2.

The communication apparatus control unit 3 according to the exemplary embodiment controls the power supply of the power amplifier 5 to an ON state (activated state) so as to make the power amplifier 5 amplify the power of a carrier wave delivered from the FM transmitter carrier wave output unit 4 when the communication apparatus is in the closed state.

Conversely, if the communication apparatus is in the open state, the communication apparatus control unit 3 controls the power supply of the power amplifier 5 to an OFF state (stopped state) so as to make the power amplifier 5 not amplify the power of a carrier wave delivered from the FM transmitter carrier wave output unit 4.

Accordingly, if the efficiency of the FM transmitter antenna 6 is low (in this case, the communication apparatus is in the closed state), the communication apparatus control unit 3 controls the power amplifier 5 so as to make the power amplifier 5 amplify the power of a carrier wave delivered from the FM transmitter carrier wave output unit 4.

Conversely, if the efficiency of the FM transmitter antenna 6 is great (in this case, the communication apparatus is in the open state), the communication apparatus control unit 3 controls the power amplifier 5 so as to make the power amplifier 5 not amplify the power of a carrier wave delivered from the FM transmitter carrier wave output unit 4.

### [FM transmitter carrier wave output unit 4]

The FM transmitter carrier wave output unit 4 outputs a carrier wave of the FM transmitter based on the control signal inputted from the communication apparatus CPU 2.

### [Power amplifier 5]

The power amplifier 5 amplifies the power of a carrier wave delivered from the FM transmitter carrier wave output unit 4.

When the power supply of the power amplifier 5 is in the ON state (activated state), the power amplifier 5 according to the exemplary embodiment amplifies the power of the carrier wave delivered from the FM transmitter carrier wave output unit 4 and outputs the power-amplified carrier wave to the FM transmitter antenna 6.

Conversely, if the power supply of the power amplifier 5 is in the OFF state (stopped state), the power amplifier 5 does not amplify the power of the carrier wave delivered from the FM transmitter carrier wave output unit 4 and outputs, to the FM transmitter antenna 6, the carrier wave delivered from the FM transmitter carrier wave output unit 4.

Incidentally, when the power supply of the power amplifier 5 is in the OFF state (stopped state), since the carrier wave is outputted to the FM transmitter antenna 6 via the power amplifier 5 being in the stopped state, the carrier wave is attenuated in the power amplifier 5 being in the stopped state. As a result, the attenuated carrier wave is outputted to the FM transmitter antenna 6.

### [FM transmitter antenna 6]

The FM transmitter antenna 6 outputs the carrier wave inputted from the power amplifier 5 to the outside of the communication apparatus.

### [Controlling operation of communication apparatus]

Next, a controlling operation of the communication apparatus shown in Fig. 2 will be described.

When the FM transmitter is used, the opening-closing detecting unit 1 detects whether the communication apparatus is in the open state or in the closed state and outputs a control signal for identifying whether the communication apparatus is in the open state or in the closed state to the communication apparatus CPU 2.

The communication apparatus CPU 2 judges whether the communication apparatus is in the open state or in the closed state based on the control signal inputted from the opening-closing detecting unit 1, and outputs a control signal according to the open or closed state to the communication apparatus control unit 3. Moreover, the communication apparatus CPU 2 outputs, to the FM transmitter carrier wave output unit 4, a control signal for outputting a carrier wave.

When the control signal for starting carrier wave output is inputted from the communication apparatus CPU 2, the FM transmitter carrier wave output unit 4 starts the carrier wave output.

When the control signal for controlling the ON/OFF state of the power supply of the power amplifier 5 is inputted from the communication apparatus CPU 2, according to the control signal inputted from the communication apparatus CPU 2, if the communication apparatus is in the closed state, the communication apparatus control unit 3 controls the power supply of the power amplifier 5 to the ON state (activated state) so as to make the power amplifier 5 amplify the power of a carrier wave delivered from the FM transmitter carrier wave output unit 4.

If the communication apparatus is in the open state, the communication apparatus control unit 3 controls the power supply of the power amplifier 5 to the OFF state (stopped state) so as to make the power amplifier 5 not amplify the power of the carrier wave delivered from the FM transmitter carrier wave output unit 4.

If the power supply of the power amplifier 5 is in the ON state (activated state), the power amplifier 5 amplifies the power of the carrier wave delivered from the FM transmitter carrier wave output unit 4 and outputs the power-amplified carrier wave to the FM transmitter antenna 6 for outputting the carrier wave to the outside via the FM transmitter antenna 6.

Conversely, if the power supply of the power amplifier 5 is in the OFF state (stopped state), the power amplifier 5 being in the stopped state does not amplify the power of the carrier wave delivered from the FM transmitter carrier wave output unit 4 and attenuates the carrier wave delivered from the FM transmitter carrier wave output unit 4. Then the power amplifier 5 outputs the attenuated carrier wave to the FM transmitter antenna 6 for outputting the carrier wave to the outside via the FM transmitter antenna 6.

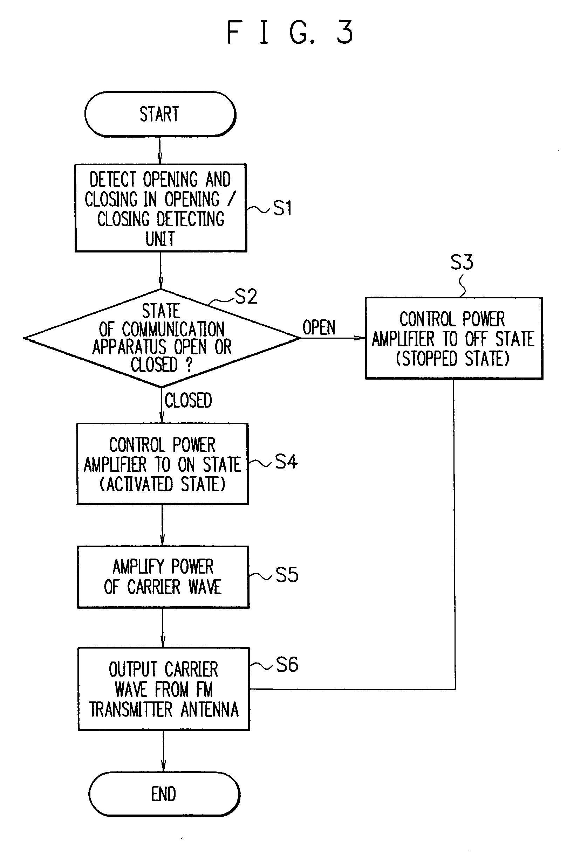

Next, a controlling operation in the communication apparatus according to the exemplary embodiment will be described with reference to Fig. 3.

First, the opening/closing detecting unit 1 of the communication apparatus detects whether the communication apparatus is in the open state or in the closed state, prior to start use of the FM transmitter (step S1).

The opening/closing detecting unit 1 of the communication apparatus judges whether the communication apparatus is in the open state or in the closed state (step S2). If the communication apparatus is in the open state (step S2/OPEN), the communication apparatus controls the power supply of the power amplifier 5 to the OFF state (stopped state) so as to make the power amplifier 5 not amplify the power of the carrier wave outputted from the FM transmitter carrier wave output unit 4 (step S3).

If the communication apparatus is in the closed state (step S2/CLOSED), the communication apparatus controls the power supply of the power amplifier 5 to the ON state (activated state) so as to make the power amplifier 5 amplify the power of the carrier wave outputted from the FM transmitter carrier wave output unit 4 (step S4).

When the power supply of the power amplifier 5 is in the ON state (activated state), the communication apparatus makes the power amplifier 5 amplify the power of the carrier wave outputted from the FM transmitter carrier wave output unit 4 (step S5), and outputs the power-amplified carrier wave to the outside via the FM transmitter antenna 6 (step S6).

When the power supply of the power amplifier 5 is in the OFF state (stopped state), the communication apparatus attenuates the carrier wave outputted from the FM transmitter carrier wave output unit 4 in the power amplifier 5 being in the stopped state, and outputs the attenuated carrier wave to the outside via the FM transmitter antenna 6 (step S6).

Thus, the communication apparatus according to the exemplary embodiment judges whether the communication apparatus is in the opens state or in the closed state; when the communication apparatus is in the closed state, determines that the efficiency of the FM transmitter antenna 6 is bad; and then controls the power supply of the power amplifier 5 to the ON state (activated state) so as to make the power amplifier 5 amplify the power of the carrier wave outputted from the FM transmitter carrier wave output unit 4.

Also, when the communication apparatus is in the open state, the communication apparatus determined that the efficiency of the FM transmitter antenna 6 is great and controls the power supply of the power amplifier 5 to the OFF state (stopped state) so as to make the power amplifier 5 being in the stopped state attenuate the carrier wave outputted from the FM transmitter carrier wave output unit 4.

Thereby, the difference in the output level of the carrier wave due to the efficiencies of the FM transmitter antenna 6 is vanished and it is possible to maintain the output level of the FM transmitter constant regardless of the open-closed state of the communication apparatus. Consequently, stable communication can be performed.

Furthermore, the output level of the carrier wave from the FM transmitter is maintained constant regardless of the open-closed state of the communication apparatus thereby an amount of electro-magnetic interference is maintained constant. Therefore, it is possible to perform communication that is stipulated in a law regardless of the open-closed state of the communication apparatus.

The above-described exemplary embodiment is a preferable embodiment of the present invention, and is not one that limits the scope of the present invention to the exemplary embodiment only. Those skilled in the art will appreciate that various adaptations and modifications of the above-described exemplary embodiment can be configured without departing from the scope of the present invention.

For example, the controlling operation in the communication apparatus according to the above-described exemplary embodiment can be executed using hardware or software, or composite structure of both.

Furthermore, when the processing is executed using the software, it is possible to install a program storing a processing sequence in a memory in a computer built in dedicated hardware, and to execute the program. Alternatively, it is possible to install a program in a general-purpose computer that can execute various processing and to make the computer execute the program.

For example, it is possible to store the program beforehand in a hard disk or ROM (Read Only Memory) as a recording medium. Alternatively, it is possible to store (record) the program temporary or permanently in a removable medium such as a floppy (registered trademark) disk, CD-ROM (Compact Disk Read Only Memory), MO (Magneto Optical) disk, DVD (Digital Versatile Disk), magnetic disk, a semiconductor memory or the like. Such removable recording medium can be provided as package software.

In addition to that the program is installed in the computer from any of the above removable recording medium, the program can be transmitted via wireless link from the download site to the computer, transmitted to the computer by wire via a network, such as a LAN (Local Area Network) or the Internet. Then, the computer receives the transmitted program, and can install the program on a recording medium, such as a built-in hard disk.

Furthermore, the processing can be executed not only in a time series in accordance with the processing operations described in the above-described exemplary embodiment, but also can be executed parallelly or individually in accordance with processing capacity of an apparatus that executed the processing, or necessity.

This application is based upon and claims the benefit of priority from Japanese patent application No. 2007-110894, filed on April 19, 2007, the disclosure of which is incorporated herein in its entirety by reference.

### INDUSTRIAL APPLICABILITY

The present invention can be applied to a device mounting a FM transmitter function.

### BRIEF DESCRIPTION OF THE DRAWING

[FIG. 1] is a diagram showing a structure of a communication apparatus related to the present invention.
[FIG. 2] is a diagram showing a configuration of a communication apparatus in accordance with an exemplary embodiment.
[FIG. 3] is a flowchart showing a controlling operation of the communication apparatus in accordance with the exemplary embodiment.

### EXPLANATION OF REFERENCE NUMERALS

- 1: Opening/closing detecting unit
- 2: Communication apparatus CPU
- 3: Communication apparatus control unit
- 4: FM transmitter carrier wave output unit
- 5: Power amplifier
- 6: FM transmitter antenna

## Claims

1. A communication apparatus that includes an amplifier for amplifying the power of a carrier wave, comprising:
control means for judging whether the communication apparatus is in an open state or a closed state; and controlling a power supply of the amplifier to an activated state when the communication apparatus is in the closed state, and controlling the power supply of the amplifier to a stopped state when the communication apparatus is in the open state.

2. The communication apparatus according to claim 1, wherein the control means controls, when the communication apparatus is in the closed state, the power of the amplifier to the activated state and outputs a carrier wave, which is power-amplified in the amplifier being in the activated state, through an antenna; and controls, when the communication apparatus is in the open state, the power of the amplifier to the stopped state and outputs a carrier wave, which is attenuated in the amplifier being in the stopped state, through the antenna.

3. The communication apparatus according to claim 1 or 2, further comprising opening/closing detecting means for detecting whether the communication apparatus is in the open state or in the closed state, wherein the control means judges whether the communication apparatus is in the open state or in the closed state according to the opening/closing detecting means.

4. The communication apparatus according to one of claims 1 to 3, wherein the control means performs the control when a carrier wave starts to be outputted.

5. The communication apparatus according to one of claims 1 to 4, wherein the carrier wave is a carrier wave of an FM transmitter.

6. A communication control method performed in a communication apparatus that includes an amplifier for amplifying the power of a carrier wave, comprising:
a controlling step of judging whether the communication apparatus is in an open state or a closed state; and controlling a power supply of the amplifier to an activated state when the communication apparatus is in the closed state, and controlling the power supply of the amplifier to a stopped state when the communication apparatus is in the open state.

7. A communication control program executed in a communication apparatus that includes an amplifier for amplifying the power of a carrier wave, the communication control program causes the communication apparatus to execute process including:
controlling process of judging whether the communication apparatus is in an open state or a closed state; and controlling a power supply of the amplifier to an activated state when the communication apparatus is in the closed state, and controlling the power supply of the amplifier to a stopped state when the communication apparatus is in the open state.
